# EUROPEAN PATENT APPLICATION

(11) **EP 4 683 035 A1**
(43) Date of publication of application: **21.01.2026**
(21) Application number: 23934555.6
(22) Date of filing: 27.04.2023
(51) Int. Cl.: H01M 10/44, H02J 7/00, H01M 10/0525

(54) **CHARGING METHOD AND APPARATUS, ELECTRONIC DEVICE, AND COMPUTER-READABLE STORAGE MEDIUM**

(71) Applicant: Contemporary Amperex Technology Co., Limited, Ningde, Fujian 352100 (CN)
(72) Inventor: JI, Cheng, Ningde, Fujian 352100 (CN); LI, Baiqing, Ningde, Fujian 352100 (CN)
(74) Representative: Gong, Jinping
(86) International application number: PCT/CN2023/091302
(87) International publication number: WO 2024/221359

(57) **Abstract**

This application discloses a charging method and apparatus, an electronic device, and a computer-readable storage medium, where the method includes: during a process of charging a secondary battery, charging the secondary battery with a first charging current until a SOC of the secondary battery reaches a preset value; and under a condition that the SOC of the secondary battery reaches the preset value, charging the secondary battery with a second charging current. A minimum value of the first charging current is greater than a maximum value of the second charging current. A positive electrode active material of the secondary battery includes LiMPO₄, where M includes Mn and Fe elements.

## Description

### TECHNICAL FIELD

This application relates to the field of battery charging technology, specifically to a charging method and apparatus, an electronic device, and a computer-readable storage medium.

### BACKGROUND

With the characteristics such as high capacity, high energy density, excellent charge-discharge cycling performance, and the ability to maintain rated output over a long period, lithium-ion secondary batteries have been widely applied in energy storage power systems such as hydroelectric, thermal, wind, and solar power stations, as well as in electric tools, electric bicycles, electric motorcycles, electric vehicles, military equipment, aerospace, and various other fields.

Currently, lithium batteries using lithium manganese iron phosphate as the positive electrode active material in the positive electrode plate are widely used due to their advantage of high capacity. However, the capacity of lithium manganese iron phosphate batteries cannot be fully realized.

### SUMMARY

In view of the above problem, this application provides a charging method and apparatus, an electronic device, and a computer-readable storage medium, which can resolve the problem that lithium manganese iron phosphate batteries cannot realize full capacity utilization.

According to a first aspect, this application provides a charging method, where the method includes: during a process of charging a secondary battery, charging the secondary battery with a first charging current until a SOC of the secondary battery reaches a preset value; and under a condition that the SOC of the secondary battery reaches the preset value, charging the secondary battery with a second charging current; where a minimum value of the first charging current is greater than a maximum value of the second charging current; and a positive electrode active material of the secondary battery includes LiMPO₄, where M includes Mn and Fe elements.

In the technical solution of this embodiment of this application, this solution, during the process of charging the secondary battery, a larger first charging current is first used to charge the secondary battery until the SOC of the secondary battery reaches the preset value. Charging with a large first charging current enables the secondary battery to self-generate heat, causing the SOC of the secondary battery to reach the preset value, accompanied by an increase in battery temperature. An increase in a charging temperature of the secondary battery helps to increase lithium ion deintercalation speed and depth in an Mn plateau segment, not only shortening a charging time of the secondary battery and increasing a charging rate of the secondary battery, but also enhancing capacity utilization of the secondary battery. Additionally, under a condition that the SOC of the secondary battery reaches the preset value, there is an increase or a relatively significant increase in battery temperature. Due to slow heat dissipation during a temperature reduction process, the secondary battery can maintain a relatively high temperature (for example, higher than ambient temperature) during subsequent charging, even when subsequently charged with a small second charging current during a subsequent charging process. This can increase the capacity and charging rate of the secondary battery, thereby allowing most of the charging process or the entire charging process of the secondary battery to be performed in a relatively high temperature environment, and further increasing the capacity and charging efficiency of the secondary battery. In addition, charging with a small second charging current can save electrical energy resources while ensuring the capacity utilization of the secondary battery. Furthermore, the charging method designed in this solution achieves self-generation of heat through a large cell current (for example, greater than a charging current in a typical constant-current charging process) without modifying heating device for a cell structure, reducing cell costs while improving the applicability of the designed secondary battery, thereby making the secondary battery suitable for various application scenarios.

In some embodiments, the positive electrode material includes at least one of the following materials: LiMn_{1-y}Fe_{y}PO₄, where y is any value in a range of 0.001 to 0.5; Li₁₊ₜMn_{1-c}Fe_{c}P_{1-z}R_{z}O₄, where t is any value in a range of -0.100 to 0.100, c is any value in a range of 0.001 to 0.500, z is any value in a range of 0.001 to 0.100, and R includes one or more elements selected from B (boron), S, Si, and N; and Li_{1+w}CₘMn₁₋ᵤFeᵤP₁₋ₐRₐO₄₋ₙDₙ, where C includes one or more elements selected from Zn, Al, Na, K, Mg, Nb, Mo, and W, R includes one or more elements selected from B (boron), S, Si, and N, D includes one or more elements selected from S, F, Cl, and Br, w is any value in a range of -0.100 to 0.100, u is any value in a range of 0.001 to 0.500, a is any value in a range of 0.001 to 0.100, n is any value in a range of 0.001 to 0.1, and m is any value in a range of 0.001 to 0.1.

In some embodiments, a current value of the first charging current decreases as a SOC value of the secondary battery increases.

In some embodiments, before the SOC value of the secondary battery reaches the preset value, a plurality of SOC intervals are provided, each SOC interval corresponds to a charging current, and different SOC intervals correspond to different charging currents; where the first charging current includes charging currents corresponding to different SOC intervals. In this implementation, a plurality of SOC intervals are provided, and each SOC interval corresponds to a charging current, such that the first charging current changes only after a period of charging, avoiding the impact of excessively rapid changes in charging current on battery charging, thus enhancing charging stability while fully realizing the capacity of the secondary battery.

In some embodiments, the charging current corresponding to a SOC interval is less than or equal to a maximum charging current allowed by a minimum SOC value in the corresponding SOC interval. In these embodiments, a charging current corresponding to the SOC interval is less than or equal to a maximum charging current allowed by the minimum SOC value in the corresponding SOC interval, such that the used first charging current, while increasing the battery temperature, does not exceed the maximum charge capacity of the battery, thereby avoiding lithium precipitation issues of the battery caused by currents exceeding the charge capacity, and extending the lifespan of the secondary battery.

In some embodiments, before the SOC value of the secondary battery reaches the preset value, a plurality of SOC intervals are provided, each SOC interval corresponds to a charging current range, and in different SOC intervals, a current within the charging current range is selected as needed for charging; where the first charging current includes currents within the plurality of SOC intervals.

In some embodiments, a current value of the second charging current is a constant value. In this solution, the temperature is increased when the secondary battery is charged with the first charging current. Therefore, during subsequent constant-current or constant-voltage charging, the battery temperature is maintained at a high level, thereby avoiding polarization of the secondary battery through constant-current charging at the second charging current while increasing the capacity and charging rate of the secondary battery, and extending the lifespan of the battery.

In some embodiments, a current value of the second charging current decreases as the SOC value increases.

In some embodiments, the first charging current is any current from 0.36C to 4.92C, and the second charging current is any current from 0.3C to 1.0C.

In some embodiments, the preset value is f*S, where f is a molar proportion of Fe element in the Mn and Fe elements in the positive electrode active material, and S is the SOC value of the secondary battery in a fully charged state.

According to a second aspect, this application provides a charging apparatus, where the apparatus includes a charging module; and the charging module is configured to perform the method described in the first aspect or in any optional implementation of the first aspect to charge a secondary battery. A positive electrode active material of the secondary battery includes LiMPO₄, where M includes Mn and Fe elements.

In the technical solution of this embodiment of this application, according to this solution, during the process of charging the secondary battery, a large first charging current is first used to charge the secondary battery until a SOC of the secondary battery reaches the preset value. Charging with a larger first charging current enables the secondary battery to self-generate heat, causing the SOC of the secondary battery to reach the preset value, accompanied by an increase in battery temperature. An increase in a charging temperature of the secondary battery helps to increase the lithium ion deintercalation speed and depth in an Mn plateau segment, not only shortening a charging time of the secondary battery and increasing a charging rate of the secondary battery, but also enhancing the capacity utilization of the secondary battery. Additionally, under a condition that the SOC of the secondary battery reaches the preset value, there is an increase or a relatively significant increase in battery temperature. Due to slow heat dissipation during a temperature reduction process, the secondary battery can maintain a relatively high temperature (for example, higher than ambient temperature) during subsequent charging, even when subsequently charged with a small second charging current during a subsequent charging process. This can increase the capacity and charging rate of the secondary battery, thereby allowing most of the charging process or the entire charging process of the secondary battery to be performed in a relatively high temperature environment, and further increasing the capacity and charging efficiency of the secondary battery. Simultaneously, charging with a small second charging current can save electrical energy resources while ensuring the capacity utilization of the secondary battery. Furthermore, the charging method designed in this solution achieves self-generation of heat through a large cell current (for example, greater than a charging current in a typical constant-current charging process) without modifying a heating device for a cell structure, reducing cell costs while improving the applicability of the designed secondary battery, thereby making the secondary battery suitable for various application scenarios.

According to a third aspect, this application provides an electronic device, including a memory and a processor, where the memory has a computer program stored therein, and the processor, when executing the computer program, performs the method described in the first aspect or in any optional embodiment of the first aspect.

According to a fourth aspect, this application provides a computer-readable storage medium, where a computer program is stored in the computer-readable storage medium, and the computer program, when executed by a processor, performs the method described in the first aspect or in any optional embodiment of the first aspect.

According to a fifth aspect, this application provides a computer program product, where the computer program product, when running on a computer, causes the computer to perform the method described in the first aspect or in any optional embodiment of the first aspect.

The above description is merely an overview of the technical solutions of this application. To enable a clearer understanding of the technical means of this application, implementation may be carried out in accordance with the content of the specification, and to make the above and other objectives, features, and advantages of this application more apparent and understandable, specific implementations of this application are provided below.

### BRIEF DESCRIPTION OF DRAWINGS

Through reading the detailed description of the preferred implementations below, various other advantages and benefits will become clear to those skilled in the art. The drawings are provided solely for the purpose of illustrating the preferred implementations and are not considered as a limitation on this application. Moreover, throughout all drawings, the same reference numerals denote the same components. In the accompanying drawings:
FIG. 1 is a schematic structural diagram of a vehicle provided by this application;
FIG. 2 is a first schematic flowchart of a charging method provided by this application;
FIG. 3 is a schematic structural diagram of a charging apparatus provided by this application; and
FIG. 4 is a schematic structural diagram of an electronic device provided by this application.

Reference numerals in the detailed description are as follows:
10. vehicle; 100. battery; 200. controller; 300. motor; 300A. charging module; 4. electronic device; 401. processor; 402. memory; and 403. communication bus.

### DETAILED DESCRIPTION

The embodiments of the technical solutions of this application will be described in detail below with reference to the accompanying drawings. The following embodiments are merely intended for a clearer description of the technical solutions of this application and therefore are used as examples, which do not constitute any limitations on the protection scope of this application.

Unless otherwise defined, all technical and scientific terms used herein have the same meaning as commonly understood by those skilled in the technical field of this application; the terms used herein are solely for the purpose of describing specific embodiments and are not intended to limit this application; the terms "include", "comprise", and any variations thereof in the specification, claims, and the above description of the drawings of this application are intended to cover non-exclusive inclusion.

In the description of the embodiments of this application, technical terms such as "first" and "second" are used only to distinguish between different objects and should not be understood as indicating or implying relative importance or implicitly indicating the number, specific order, or primary-secondary relationship of the indicated technical features. In the description of the embodiments of this application, "a plurality of" means two or more, unless otherwise explicitly and specifically defined.

In this specification, reference to "embodiment" means that specific features, structures, or characteristics described with reference to the embodiment may be incorporated in at least one embodiment of this application. The appearance of this phrase in various places in the specification does not necessarily refer to the same embodiment, nor is it an independent or alternative embodiment mutually exclusive with other embodiments. Those skilled in the art explicitly and implicitly understand that the embodiments described herein may be combined with other embodiments.

In the description of the embodiments of this application, the term "and/or" is only an associative relationship for describing associated objects, indicating that three relationships may be present. For example, A and/or B may indicate the following three cases: presence of only A, presence of both A and B, and presence of only B. Additionally, the character "/" herein generally indicates that the contextually associated objects are in an "or" relationship.

In the description of the embodiments of this application, the term "a plurality of" refers to two or more (including two), similarly, "a plurality of groups" refers to two or more groups (including two groups), and "a plurality of pieces" refers to two or more pieces (including two pieces).

In the description of the embodiments of this application, the orientation or positional relationships indicated by technical terms such as "center", "longitudinal", "lateral", "length", "width", "thickness", "upper", "lower", "front", "rear", "left", "right", "vertical", "horizontal", "top", "bottom", "inner", "outer", "clockwise", "counterclockwise", "axial", "radial", and "circumferential" are based on the orientation or positional relationships shown in the drawings. These terms are used only to facilitate the description of the embodiments of this application and simplify the description, and do not indicate or imply that the referred apparatus or element must have a specific orientation, be constructed, and operated in a specific orientation, and therefore should not be understood as limiting the embodiments of this application.

In the description of the embodiments of this application, unless otherwise explicitly specified and defined, technical terms such as "mounting", "connection", "join", and "fastening" should be understood in a broad sense. For example, they may refer to a fixed connection, a detachable connection, or an integral formation; they may refer to a mechanical connection or an electrical connection; and they may refer to a direct connection or an indirect connection through an intermediate medium, an internal communication between two elements, or an interaction between two elements. For those of ordinary skill in the art, the specific meanings of the above terms in the embodiments of this application can be understood based on specific circumstances.

With the characteristics such as high capacity, high energy density, excellent charge-discharge cycling performance, and the ability to maintain rated output over a long period, lithium-ion secondary batteries have been widely applied in energy storage power systems for hydroelectric, thermal, wind, and solar power stations, as well as in electric tools, electric bicycles, electric motorcycles, electric vehicles, military equipment, aerospace, and various other fields.

The inventors of this application have noted that lithium manganese iron phosphate batteries, due to their higher voltage platform compared to lithium iron phosphate batteries, have higher energy density than lithium iron phosphate batteries while maintaining the safety and low cost of lithium iron phosphate batteries, so that lithium manganese iron phosphate batteries are widely used in the current market.

Although lithium manganese iron phosphate batteries have the advantage of high energy density, the lithium deintercalation speed of a positive electrode active material on a positive electrode plate of a lithium manganese iron phosphate battery is slow, making it difficult to fully utilize the capacity of the lithium manganese iron phosphate battery. The inventors of this application have found that increasing the temperature of lithium manganese iron phosphate batteries can realize capacity utilization of the batteries.

The inventors of this application have found through research that increasing the charging current to a certain extent can cause a cell of a lithium manganese iron phosphate battery to self-generate heat, increasing the charging temperature of the lithium manganese iron phosphate battery and achieving high-temperature charging, thereby resolving the problem of incomplete capacity utilization when lithium manganese iron phosphate batteries are charged at room temperature.

Through in-depth research, the inventors of this application have designed a charging method and apparatus, an electronic device, and a computer-readable storage medium for a secondary battery with a positive electrode active material of LiMPO₄ in a positive electrode plate. A secondary battery is charged with a first charging current until a SOC of the secondary battery reaches a preset value, so that a high-rate first charging current causes the secondary battery to self-generate heat and increases the battery temperature. An increase in cell temperature helps to increase the lithium ion deintercalation speed and depth in an Mn plateau segment, not only shortening a charging time of the secondary battery but also enhancing the capacity utilization of the secondary battery. Furthermore, according to this solution, after the SOC of the secondary battery reaches the preset value, charging is performed with a small second charging current, thereby saving electrical energy resources while ensuring the capacity utilization of the secondary battery.

The charging method and apparatus, the electronic device, and the computer-readable storage medium disclosed in the embodiments of this application can be applied to power devices using a battery as a power source, where the power devices include, but are not limited to, electric apparatuses such as vehicles, ships, or aircraft.

For ease of description, the following embodiments uses an example in which an electric apparatus is a vehicle 10 for description.

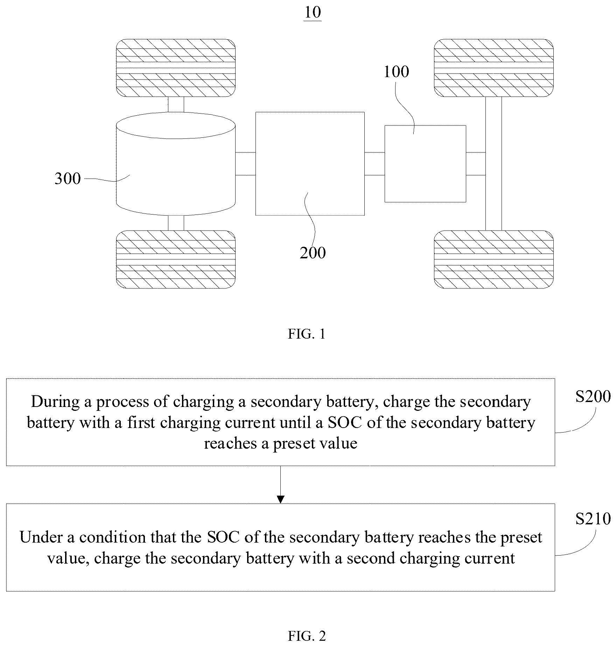

Refer to FIG. 1. FIG. 1 is a schematic structural diagram of a vehicle 10 according to some embodiments of this application. The vehicle 10 may be a fossil fuel vehicle, a natural-gas vehicle, or a new energy vehicle, where the new energy vehicle may be a battery electric vehicle, a hybrid electric vehicle, a range-extended vehicle, or the like. The interior of the vehicle 10 is provided with a battery 100, where the battery 100 may be disposed at the bottom, front, or rear of the vehicle 10. The battery 100 may be configured to supply power to the vehicle 10. For example, the battery 100 may be used as an operational power source for the vehicle 10. The vehicle 10 may further include a controller 200 and a motor 300, where the controller 200 is configured to control the battery 100 to supply power to the motor 300, for example, to meet the power demands for starting, navigating, and driving the vehicle 10.

In some embodiments of this application, the battery 100 may not only serve as an operational power source for the vehicle 10 but also as a driving power source for the vehicle 10, replacing or partially replacing fuel or natural gas to provide driving power for the vehicle 10.

It should be noted that, in this application, the battery 100 serves as the driving power source for the vehicle 10 to provide driving power for the vehicle 10.

According to some embodiments of this application, a charging method according to one embodiment of this application is provided. This charging method can be used to control the charging of a secondary battery, where the secondary battery is a battery with a positive electrode active material of LiMPO₄ in a positive electrode plate. The charging method may be executed by a computing device, where the computing device includes, but is not limited to, a controller, a chip, and a battery management system (Battery Management System, BMS). As shown in FIG. 2, the charging method may be implemented in the following manner, including the following steps.

Step S200: During a process of charging a secondary battery, charge the secondary battery with a first charging current until a SOC of the secondary battery reaches a preset value.

Step S210: Under a condition that the SOC of the secondary battery reaches the preset value, charge the secondary battery with a second charging current.

In the above implementation, the positive electrode active material is LiMPO₄, where M includes Mn and Fe elements, meaning that the M element may include Mn and Fe; alternatively, in addition to Mn and Fe, the M element may further optionally include a non-metal element, such as one or more elements selected from B, S, Si, and N; alternatively, in addition to Mn, Fe, and the non-metal element, the M element may further include an alkali metal element (for example, one or both of Na and K elements), an alkaline earth metal element (for example, Mg), a transition metal element (for example, one or more elements selected from Zn, Al, Nb, Mo, and W), a halogen element (for example, one or more elements selected from F, Cl, and Br), and the like. It can be understood that the M element may be a doping element for the Mn element or the Fe element, the M element may be a doping element for the Li element, or the M element may be a doping element for the P element or the O element.

In the above implementation, the computing device (for example, battery management system BMS) can acquire a current state of the secondary battery, such as a charging state, an operating state, and an idle state, where the charging state refers to a state in which the secondary battery is connected to an external power supply device and the electrical energy from the external power supply device is charged into the secondary battery; the operating state, also referred to as a discharging state, is a state in which the secondary battery releases stored electrical energy as external power; and the idle state refers to a state in which the secondary battery is neither charged nor discharged. Specifically, the computing device can identify whether the external power supply device has a charging current, or whether the secondary battery currently has a charging current/charging voltage, to determine whether the secondary battery is in the charging state.

On the basis mentioned above, the secondary battery is connected to the external power supply device and the electrical energy from the external power supply device is charged into the secondary battery, that is, the computing device charges the secondary battery. In the design of this solution, during the charging process of the secondary battery, the secondary battery is first charged with a first charging current until the SOC of the secondary battery reaches a preset value, and under a condition that the SOC of the secondary battery reaches the preset value, the secondary battery is charged with a second charging current.

The above SOC represents the state of charge (State of Charge) of the battery, which is used to reflect a remaining capacity of the battery, and is numerically defined as a ratio of the remaining capacity of the battery to the capacity of the battery.

During the charging process, the SOC of the secondary battery continuously changes. Specifically, a SOC value of the secondary battery continuously increases during the charging process. As described hereinbefore, a current value of the first charging current decreases as the SOC value of the secondary battery increases. Therefore, in the design of this solution, under a condition that the SOC of the secondary battery is less than the preset value, the first charging current changes with the change of the SOC value of the secondary battery, to be specific, a larger SOC value of the secondary battery indicates a smaller designed first charging current value. However, in the design of this solution, during the change process of the first charging current, the first charging current always remains greater than the second charging current, to be specific, a minimum value of the first charging current is greater than a maximum value of the second charging current. This allows the secondary battery, when the SOC value is less than the preset value, to be charged with a large first charging current to achieve self-generation of heat of the secondary battery, increasing the temperature of the secondary battery. Thus, the secondary battery maintains a high temperature during a subsequent charging process (when the SOC value is greater than the preset value) and can be charged with a small second charging current, enhancing the capacity utilization of the secondary battery and increasing the charging rate of the secondary battery while saving charging resources.

The above phrases "a current value of the first charging current decreases as the SOC value of the secondary battery increases" and "the first charging current may change with the change of the SOC value of the secondary battery" mean that, generally, a charging current at a large SOC is smaller than a charging current at a small SOC. That is, throughout the charging process, the charging current increases, but this does not absolutely mean that the charging current increases linearly. For example, within a certain SOC interval, the charging current value may be constant, but in a higher SOC interval, the charging current value correspondingly decreases.

With the above-designed charging method, according to this solution, during the process of charging the secondary battery, a large first charging current is first used to charge the secondary battery until the SOC of the secondary battery reaches the preset value. Charging with a large first charging current enables the secondary battery to self-generate heat, causing the SOC of the secondary battery to reach the preset value, accompanied by an increase in battery temperature. An increase in a charging temperature of the secondary battery helps to increase the lithium ion deintercalation speed and depth in an Mn plateau segment, not only shortening a charging time of the secondary battery and increasing a charging rate of the secondary battery, but also enhancing the capacity utilization of the secondary battery. Additionally, under a condition that the SOC of the secondary battery reaches the preset value, there is an increase or a relatively significant increase in battery temperature. Due to slow heat dissipation during a temperature reduction process, the secondary battery can maintain a relatively high temperature (for example, higher than ambient temperature) during subsequent charging, even when charged with a small second charging current. This can increase the capacity and charging rate of the secondary battery, thereby allowing most of the charging process or the entire charging process of the secondary battery to be performed in a relatively high temperature environment, and further increasing the capacity and charging efficiency of the secondary battery. Simultaneously, charging with a small second charging current can save electrical energy resources while ensuring the capacity utilization of the secondary battery. Furthermore, the charging method designed in this solution achieves self-generation of heat through a large cell current (for example, greater than a charging current in a typical constant-current charging process) without modifying a heating device for a cell structure, reducing cell costs while improving the applicability of the designed secondary battery, thereby making the secondary battery suitable for various application scenarios.

In an optional implementation of this embodiment, in a possible implementation, the computing device can charge the secondary battery with the first charging current immediately upon the secondary battery being connected for charging.

In another possible implementation, since a battery with LiMPO₄ first undergoes an Fe element plateau and then an Mn element plateau; based on this, according to this solution, in addition to charging the secondary battery with the first charging current immediately upon the secondary battery being connected for charging, the secondary battery may also undergo a short-term conventional charging. After lithium deintercalation of the Fe element is complete, the secondary battery is then charged with the first charging current, allowing the Mn element to undergo lithium deintercalation in a relatively high temperature environment. In a specific example, according to this solution, the secondary battery may first undergo short-term constant-voltage charging. Under a condition that the secondary battery reaches a preset cutoff voltage through constant-voltage charging, according to this solution, the secondary battery is charged with the first charging current, improving the accuracy of a temperature increase phase of the secondary battery, thereby ensuring that the temperature increase can accurately correspond to a lithium deintercalation phase of the Mn element.

In an optional implementation of this embodiment, in a possible implementation, a current value of the first charging current decreases as the SOC value of the secondary battery increases. Specifically, according to this solution, the SOC value of the secondary battery can be calculated in real time during the charging process of the secondary battery, and the first charging current is determined based on the SOC value calculated in real time. A method for calculating the SOC value of the secondary battery in real time may specifically involve calibrating an open-circuit voltage during the charging process of the secondary battery with a corresponding SOC value in advance, so that the corresponding SOC value can be obtained by collecting the open-circuit voltage during the charging process of the secondary battery.

In another possible implementation, according to this solution, SOC values less than the preset value can be divided into a plurality of SOC intervals, with each SOC interval corresponding to a charging current in advance, where different SOC intervals correspond to different charging currents. In the process described hereinbefore where the first charging current changes with the change of the SOC value, a current value of the first charging current includes the charging currents corresponding to different SOC intervals.

In a possible example, according to this solution, an interval length may be set. Assuming that a SOC interval length is 5%, under a condition that the preset value is 45%, the plurality of SOC intervals obtained by division may include [0%, 5%), [5%, 10%), [10%, 15%), [15%, 20%), [20%, 25%), [25%, 30%), [30%, 35%), [35%, 40%), and [40%, 45%), and each SOC interval corresponds to a charging current, where the first charging current is a charging current corresponding to a SOC interval in which the SOC value of the secondary battery is located during the charging process. The SOC interval [0%, 5%) obtained by division indicates a SOC from 0% to 5%, excluding 5%; for another example, the SOC interval [5%, 10%) obtained by division indicates a SOC from 5% to 10%, excluding 10%, and so forth.

In a specific example, in the case described hereinbefore where each SOC interval corresponds to a charging current, as shown in Table 1, the charging current corresponding to the SOC interval [0%, 5%) may be 4.1C, the charging current corresponding to the SOC interval [5%, 10%) may be 3.53C, the charging current corresponding to the SOC interval [10%, 15%) may be 2.95C, the charging current corresponding to the SOC interval [15%, 20%) may be 2.5C, the charging current corresponding to the SOC interval [20%, 25%) may be 2.05C, the charging current corresponding to the SOC interval [25%, 30%) may be 1.79C, the charging current corresponding to the SOC interval [30%, 35%) may be 1.54C, the charging current corresponding to the SOC interval [35%, 40%) may be 1.18C, and the charging current corresponding to the SOC interval [40%, 45%) may be 1.09C. To be specific, the secondary battery is charged with the first charging current of 4.1C when the SOC interval is [0%, 5%), the secondary battery is charged with the first charging current of 3.53C when the SOC interval is [5%, 10%), the secondary battery is charged with the first charging current of 2.95C when the SOC interval is [10%, 15%), the secondary battery is charged with the first charging current of 2.5C when the SOC interval is [15%, 20%), the secondary battery is charged with the first charging current of 2.05C when the SOC interval is [20%, 25%), the secondary battery is charged with the first charging current of 1.79C when the SOC interval is [25%, 30%), the secondary battery is charged with the first charging current of 1.54C when the SOC interval is [30%, 35%), the secondary battery is charged with the first charging current of 1.18C when the SOC interval is [35%, 40%), and the secondary battery is charged with the first charging current of 1.09C when the SOC interval is [40%, 45%).

**Table 1**

| **SOC** | **First charging current (C)** |
|---|---|
| [0%, 5%) | 4.1 |
| [5%, 10%) | 3.53 |
| [10%, 15%) | 2.95 |
| [15%, 20%) | 2.5 |
| [20%, 25%) | 2.05 |
| [25%, 30%) | 1.79 |
| [30%, 35%) | 1.54 |
| [35%, 40%) | 1.18 |
| [40%, 45%) | 1.09 |

Further, since the maximum charging current allowed by the SOC value of the secondary battery (charge capacity window) continuously decreases as the SOC increases, under a condition that each SOC interval corresponds to a charging current, the charging current corresponding to each SOC interval may be determined based on a maximum charging current allowed by a maximum SOC value of the secondary battery in the SOC interval. For example, a charging current corresponding to the SOC interval of [0%, 5%) is determined based on a maximum charging current allowed by a SOC value of 5%. If a maximum charging current allowed by the SOC value of 5% is 4.23C, the charging current corresponding to the SOC interval of [0%, 5%) is 4.23C.

In another possible implementation, according to this solution the SOC values less than the preset value can be divided into a plurality of SOC intervals, and each SOC interval can be set to correspond to a charging current range. Under a condition that the SOC of the secondary battery continuously changes during a charging phase, according to this solution, a current may be selected from a charging current range corresponding to a SOC interval in which the SOC value is located, to charge the secondary battery, where the current refers to a first charging current actually used by the secondary battery in the corresponding SOC interval. For the method of selecting the current, according to this solution, a charging current may be randomly selected from the charging current range corresponding to the SOC interval, or other selection methods may be used, such as selecting a maximum value from the charging current range corresponding to the SOC interval or a minimum value from the charging current range corresponding to the SOC interval.

In a specific example, assuming that the SOC intervals are consistent with those described above, based on this, as shown in Table 2, this solution may provide a design in which a charging current range corresponding to a SOC interval of [0%, 5%) may be [1.37C, 4.92C], a charging current range corresponding to a SOC interval of [5%, 10%) may be [1.18C, 4.23C], a charging current range corresponding to a SOC interval of [10%, 15%) may be [0.98C, 3.54C], a charging current range corresponding to a SOC interval of [15%, 20%) may be [0.83C, 3.00C], a charging current range corresponding to a SOC interval of [20%, 25%) may be [0.68C, 2.46C], a charging current range corresponding to a SOC interval of [25%, 30%) may be [0.6C, 2.15C], a charging current range corresponding to a SOC interval of [30%, 35%) may be [0.51C, 1.84C], a charging current range corresponding to a SOC interval of [35%, 40%) may be [0.39C, 1.42C], and a charging current range corresponding to a SOC interval of [40%, 45%) may be [0.36C, 1.31C].

On the basis mentioned above, under a condition that the SOC value of the secondary battery is in the SOC interval of [0%, 5%), the secondary battery may be charged with any current in the charging current range of [1.37C, 4.92C]; under a condition that the SOC value of the secondary battery is in the SOC interval of [5%, 10%), the secondary battery may be charged with any current in the charging current range of [1.18C, 4.23C]; under a condition that the SOC value of the secondary battery is in the SOC interval of [10%, 15%), the secondary battery may be charged with any current in the charging current range of [0.98C, 3.54C]; under a condition that the SOC value of the secondary battery is in the SOC interval of [15%, 20%), the secondary battery may be charged with any current in the charging current range of [0.83C, 3.00C]; under a condition that the SOC value of the secondary battery is in the SOC interval of [20%, 25%), the secondary battery may be charged with any current in the charging current range of [0.68C, 2.46C]; under a condition that the SOC value of the secondary battery is in the SOC interval of [25%, 30%), the secondary battery may be charged with any current in the charging current range of [0.6C, 2.15C]; under a condition that the SOC value of the secondary battery is in the SOC interval of [30%, 35%), the secondary battery may be charged with any current in the charging current range of [0.51C, 1.84C]; under a condition that the SOC value of the secondary battery is in the SOC interval of [35%, 40%), the secondary battery may be charged with any current in the charging current range of [0.39C, 1.42C]; and under a condition that the SOC value of the secondary battery is in the SOC interval of [40%, 45%), the secondary battery may be charged with any current in the charging current range of [0.36C, 1.31C].

The charging current range described above refers to a range that includes two range endpoints. For example, the charging current range of [1.37C, 4.92C] represents a current range from a charging current of 1.37C to a charging current of 4.92C. For another example, the charging current range of [0.36C, 1.31C] represents a current range from a charging current of 0.36C to a charging current of 1.31C.

Additionally, under a condition that the secondary battery designed in this solution is charged with a charging current from different SOC intervals, a charging current selected from a current SOC interval is preferably less than a charging current selected from a previous SOC interval. For example, under a condition that a first charging current selected for the secondary battery in the SOC interval of [0%, 5%) is 4.2C, when the SOC value of the secondary battery reaches [5%, 10%), although the charging current range corresponding to the SOC interval of [5%, 10%) is [1.18C, 4.23C], the secondary battery is preferentially charged with a first charging current less than 4.2C under this condition.

Preferably, as shown in Table 2, a charging current range corresponding to the SOC interval of [0%, 5%) may preferably be [2C, 4.2C], a charging current range corresponding to the SOC interval of [5%, 10%) may preferably be [1.8C, 3.8C], a charging current range corresponding to the SOC interval of [10%, 15%) may preferably be [1.7C, 3.2C], a charging current range corresponding to the SOC interval of [15%, 20%) may preferably be [1.4C, 2.8C], a charging current range corresponding to the SOC interval of [20%, 25%) may preferably be [1.2C, 2.4C], a charging current range corresponding to the SOC interval of [25%, 30%) may preferably be [0.8C, 1.9C], a charging current range corresponding to the SOC interval of [30%, 35%) may preferably be [0.7C, 1.7C], a charging current range corresponding to the SOC interval of [35%, 40%) may preferably be [0.5C, 1.3C], and a charging current range corresponding to the SOC interval of [40%, 45%) may preferably be [0.4C, 1.2C].

**Table 2**

| **SOC** | **First charging current (C)** | **Preferred first charging current (C)** |
|---|---|---|
| [0%, 5%) | 1.37-4.92 | 2-4.2 |
| [5%, 10%) | 1.18-4.23 | 1.8-3.8 |
| [10%, 15%) | 0.98-3.54 | 1.7-3.2 |
| [15%, 20%) | 0.83-3.00 | 1.4-2.8 |
| [20%, 25%) | 0.68-2.46 | 1.2-2.4 |
| [25%, 30%) | 0.6-2.15 | 0.8-1.9 |
| [30%, 35%) | 0.51-1.84 | 0.7-1.7 |
| [35%, 40%) | 0.39-1.42 | 0.5-1.3 |
| [40%, 45%) | 0.36-1.31 | 0.4-1.2 |

In the above implementation, a charging current corresponding to each SOC value of the secondary battery, a charging current corresponding to each SOC interval, or a charging current range corresponding to each SOC interval is pre-configured in a computing device. Additionally, the computing device can adjust the charging current of the secondary battery by adjusting a charging current inputted by a charging pile or charging gun connected to the secondary battery.

It should be noted that a maximum charging current allowed by each SOC value of the secondary battery is determined based on a material of the secondary battery. Specifically, a maximum charging current allowed by a SOC of the secondary battery is related to an electrolyte and graphite of the secondary battery.

In an optional implementation of this embodiment, as described hereinbefore, under a condition that a SOC value of the secondary battery reaches a preset value, the secondary battery is charged with a second charging current.

In a possible implementation, to avoid polarization of the secondary battery, the second charging current may be a constant value, thereby reducing polarization of the secondary battery caused by a temperature increase process through constant-current charging, and further extending the lifespan of the battery. Based on this, under a condition that the SOC value of the secondary battery reaches the preset value, according to this solution, the secondary battery may undergo constant-current charging with the second charging current until charging is stopped after the SOC value of the secondary battery reaches a fully charged state (100%).

Specifically, under a condition that the second charging current is a constant value, the second charging current may be any current value from 0.3C to 1.0C. Preferably, the second charging current may be 0.33C.

In another possible implementation, the second charging current designed in this solution may be a variable current. Specifically, a current value of the second charging current may also decrease as a SOC value of the secondary battery increases.

In a possible implementation, the preset value in the previous description that "the secondary battery is charged with a first charging current until a SOC of the secondary battery reaches a preset value" may be determined based on a molar proportion f of the Fe element in the Mn and Fe elements in the active material. The molar proportion of the Fe element refers to a ratio of a molar content of the Fe element to a sum of a molar content of the Fe element and a molar content of the Mn element. For example, if the molar content of the Fe element is Mol1 and the molar content of the Mn element is Mol2, f is Mol1:(Mol1+Mol2). Specifically, the preset value may be set as f*S, where S is a SOC value of the secondary battery in a fully charged state, and f*S is a product of f and S. Generally, the SOC value of the secondary battery in the fully charged state is typically 1, that is, S is typically a value of 1. However, with usage and degradation of the secondary battery, the SOC value of the secondary battery in the fully charged state may be less than 1, such as 0.99, 0.98, 0.97, 0.96, or 0.95. Based on this, S designed in this solution changes correspondingly with the change of the SOC value of the secondary battery in the fully charged state.

A value range of f may be 0.001-0.5, for example, a value range of f may be any one of 0.002-0.5, 0.003-0.5, 0.004-0.5, 0.005-0.5, 0.005-0.49, 0.007-0.45, 0.008-0.45, 0.009-0.45, 0.01-0.45, 0.02-0.4, 0.05-0.35, 0.07-0.3, 0.1-0.25, 0.1-0.2, or 0.15-0.2.

Specifically, f may be any one of 0.001, 0.002, 0.003, 0.004, 0.005, 0.007, 0.008, 0.009, 0.01, 0.02, 0.05, 0.07, 0.1, 0.15, 0.2, 0.25, 0.3, 0.35, 0.4, 0.45, 0.49, or 0.5.

For example, assuming that f is 0.3, a ratio of Fe to Mn in lithium manganese iron phosphate is 3:7, and the preset value is 0.3S, to be specific, the preset value is 30% of the SOC value of the secondary battery in the fully charged state. For another example, assuming that f is 0.4, a ratio of Fe to Mn in lithium manganese iron phosphate is 4:6, and the preset value is 0.4S, to be specific, the preset value is 40% of the SOC value of the secondary battery in the fully charged state.

Additionally, it should be noted that the above values of f are all less than or equal to 0.5, to be specific, a proportion of Fe is less than or equal to a proportion of Mn. In the implementation designed in this solution, in addition to the above values, the proportion of Fe may alternatively be slightly higher than the proportion of Mn. For example, the value of f may also be 0.5-0.6, such as any one of 0.51, 0.52, 0.55, 0.57, 0.58, 0.59, or 0.6.

In another possible implementation, in addition to determining the preset value based on the proportion of Fe, this solution may also determine the preset value based on the proportion of Mn, which is similar to the method of determining the preset value based on the proportion of Fe and is not described herein again.

M in the positive electrode material LiMPO₄ designed in this solution may include the Mn element and the Fe element. In a possible implementation, LiMPO₄ may be a compound LiMn_{1-y}Fe_{y}PO₄.

For example, a preparation method of a compound LiMn_{0.80}Fe_{0.20}PO₄ includes the following steps.

Step S1: Prepare Fe-doped manganese oxalate.

919.4 g of manganese carbonate and 231.7 g of ferrous carbonate are added to a mixer and thoroughly mixed for 6 h. Then, the resulting mixture is transferred to a reactor, added with 5 L deionized water and 1260.6 g of oxalic acid dihydrate, heated to 80°C, stirred thoroughly at a rotating speed of 500 rpm for 6 h, and mixed uniformly until a reaction terminates with no bubble generation, to obtain an Fe-doped manganese oxalate suspension. Then, the suspension is filtered, dried at 120°C, and then sand-milled to obtain manganese iron oxalate particles with a particle size of 100 nm.

Step S2: Prepare LiMn_{0.80}Fe_{0.20}PO₄.

1791.4 g of the manganese iron oxalate (calculated as C₂O₄Mn_{0.80}Fe_{0.20}•2H₂O) prepared in Step S1, 369.4 g of lithium carbonate, and 1150.1 g of ammonium dihydrogen phosphate are added to 20 L deionized water, stirred thoroughly, and mixed uniformly for reaction at 80°C for 10 h to obtain a slurry. The slurry is transferred to a spray drying device for spray drying and granulation, and dried at 250°C to obtain a powder material. In a protective atmosphere (including 90% of nitrogen and 10% of hydrogen), the powder material is sintered in a roller kiln at 700°C for 4 h.

The above positive electrode active material may be a compound with a chemical formula Li₁₊ₜMn_{1-c}Fe_{c}P_{1-z}R_{z}O₄, where t is any value in a range of -0.100 to 0.100, c is any value in a range of 0.001 to 0.500, z is any value in a range of 0.001 to 0.100, and R includes one or more elements selected from B (boron), S, Si, and N. The values of t, c, and z satisfy a condition that the entire compound remains electrically neutral. A ratio of c to 1-c is 1:10 to 1:1, optionally 1:4 to 1:1. Herein, c denotes a sum of stoichiometric numbers of the Fe element doping at an Mn site. In some implementations, a ratio of z to 1-z is 1:9 to 1:999, optionally 1:499 to 1:249. Herein, z denotes a sum of stoichiometric numbers of the R element doping at a P site.

A preparation method of the compound Li₁₊ₜMn_{1-c}Fe_{c}P_{1-z}R_{z}O₄ may include the following steps.
(1) Dissolve and stir a manganese source, an iron source, and an acid in a solvent to generate a suspension of a manganese salt doped with the Fe element, filter the suspension, and dry a filter cake to obtain a manganese salt doped with the Fe element.
(2) Add a lithium source, a phosphorus source, a source of the R element, a solvent, and the manganese salt doped with the Fe element obtained in step (1) to a reaction vessel, and grind and mix them to obtain a slurry.
(3) Transfer the slurry obtained in step (2) to a spray drying device for spray drying and granulation to obtain particles.
(4) Sinter the particles obtained in step (3) to obtain a positive electrode active material.

In any implementation, the manganese source may be a manganese-containing substance known in the art for preparing lithium manganese phosphate, for example, the manganese source may be selected from one of elemental manganese, manganese dioxide, manganese phosphate, manganese oxalate, manganese carbonate, or a combination thereof. The iron source is selected from at least one of elemental substance, oxide, phosphate, oxalate, carbonate, and sulfate of iron. The acid is selected from one or more of hydrochloric acid, sulfuric acid, nitric acid, phosphoric acid, and organic acid such as oxalic acid, for example, it may be oxalic acid. The source of the R element is selected from at least one of sulfate, borate, nitrate, and silicate of the R element.

For example, a preparation method of a compound Li_{1.001}Mn_{0.999}Fe_{0.001}P_{0.999}Si_{0.001}O₄ includes the following steps.

Step S1: Prepare Fe-doped manganese oxalate.

1148.2 g of manganese carbonate and 1.2 g of ferrous carbonate are added to a mixer and thoroughly mixed for 6 h. Then, the resulting mixture is transferred to a reactor, added with 5 L deionized water and 1260.6 g of oxalic acid dihydrate, heated to 80°C, stirred thoroughly at a rotating speed of 500 rpm for 6 h, and mixed uniformly until a reaction terminates with no bubble generation, to obtain an Fe-doped manganese oxalate suspension. Then, the suspension is filtered, dried at 120°C, and sand-milled to obtain manganese iron oxalate particles with a particle size of 100 nm.

Step S2: Prepare Li_{1.001}Mn_{0.999}Fe_{0.001}P_{0.999}Si_{0.001}O₄.

1789.6 g of the manganese iron oxalate (calculated as C₂O₄Mn_{0.999}Fe_{0.001}•2H₂O) prepared in Step S1, 369.8 g of lithium carbonate, 1148.9 g of ammonium dihydrogen phosphate, and 0.8 g of silicic acid are added to 20 L deionized water, stirred thoroughly, and mixed uniformly for reaction at 80°C for 10 h to obtain a slurry. The slurry is transferred to a spray drying device for spray drying and granulation, and dried at 250°C to obtain a powder material. In a protective atmosphere (including 90% of nitrogen and 10% of hydrogen), the powder material is sintered in a roller kiln at 700°C for 4 h.

In some other implementations, the above positive electrode active material may be a compound with a chemical formula Li_{1+w}CₘMn₁₋ᵤFeᵤP₁₋ₐRₐO₄₋ₙDₙ, where C includes one or more elements selected from Zn, Al, Na, K, Mg, Nb, Mo, and W, R includes one or more elements selected from B (boron), S, Si, and N, D includes one or more elements selected from S, F, Cl, and Br, w is any value in a range of -0.100 to 0.100, u is any value in a range of 0.001 to 0.500, a is any value in a range of 0.001 to 0.100, n is any value in a range of 0.001 to 0.1, and m is any value in a range of 0.001 to 0.1. Similarly, the values of w, u, a, and m satisfy a condition that the entire compound remains electrically neutral.

A preparation method of the compound Li_{1+w}CₘMn₁₋ᵤFeᵤP₁₋ₐRₐO₄₋ₙDₙ may include the following steps.
(1) Dissolve and stir a manganese source, an iron source, and an acid in a solvent to generate a suspension of a manganese salt doped with the Fe element, filter the suspension, and dry a filter cake to obtain a manganese salt doped with the Fe element.
(2) Add a lithium source, a phosphorus source, a source of the C element, a source of the R element, a source of the D element, a solvent, and the manganese salt doped with the Fe element obtained in step (1) to a reaction vessel, and grind and mix them to obtain a slurry.
(3) Transfer the slurry obtained in step (2) to a spray drying device for spray drying and granulation to obtain particles.
(4) Sinter the particles obtained in step (3) to obtain a positive electrode active material.

In any implementation, the source of the C element is selected from at least one of elemental substance, oxide, phosphate, oxalate, carbonate, and sulfate of the C element. The manganese source may be a manganese-containing substance known in the art for preparing lithium manganese phosphate, for example, the manganese source may be selected from one of elemental manganese, manganese dioxide, manganese phosphate, manganese oxalate, manganese carbonate, or a combination thereof. The iron source is selected from at least one of elemental substance, oxide, phosphate, oxalate, carbonate, and sulfate of iron. The acid is selected from one or more of hydrochloric acid, sulfuric acid, nitric acid, phosphoric acid, and organic acid such as oxalic acid, for example, it may be oxalic acid. The source of the R element is selected from at least one of sulfate, borate, nitrate, and silicate of the R element. The source of the D element is selected from at least one of elemental substance and ammonium salt of the element D.

For an implementation where the positive electrode active material may contain Li_{1+w}CₘMn₁₋ᵤFeᵤP₁₋ₐRₐO₄₋ₙDₙ, a magnitude of w is influenced by valence states of Fe and R and magnitudes of u and a, to ensure that an entire system remains electrically neutral. If the value of w is too small, a lithium content of the entire system decreases, affecting capacity utilization of the material. The value of u limits a total amount of all doping elements; if u is too small, that is, a doping amount is too low, the doping elements do not function, and if u exceeds 0.5, the Mn content in the system is low, affecting a voltage platform of the material. The R element dopes at a P site, and since a P-O tetrahedron is relatively stable, and an excessively large value of a affects the stability of the material, the value of a is limited to 0.001 to 0.100. More specifically, w is any value in a range of -0.100 to 0.100, u is any value in a range of 0.001 to 0.500, a is any value in a range of 0.001 to 0.100, n is any value in a range of 0.001 to 0.1, and m is any value in a range of 0.001 to 0.1. For example, 1+w is selected from a range of 0.9 to 1.1, such as 0.97, 0.977, 0.984, 0.988, 0.99, 0.991, 0.992, 0.993, 0.994, 0.995, 0.996, 0.997, 0.998, or 1.01; w is selected from a range of 0.001 to 0.1, such as 0.001 or 0.005; u is selected from a range of 0.001 to 0.5, such as 0.001, 0.005, 0.02, 0.05, 0.1, 0.15, 0.2, 0.25, 0.3, 0.34, 0.345, 0.349, 0.35, or 0.4; a is selected from a range of 0.001 to 0.1, such as 0.001, 0.005, 0.08, or 0.1; n is selected from a range of 0.001 to 0.1, such as 0.001, 0.005, 0.08, or 0.1; and the positive electrode active material is electrically neutral.

Unless otherwise specified, in the above chemical formula, when a doping site has two or more of the above elements, the above limitation on the value range of w, u, a, or m is not only a limitation on a stoichiometric number of each element at the site but also a limitation on a sum of stoichiometric numbers of the elements at the site. For example, if there is a compound with a chemical formula Li_{1+w}Mn₁₋ᵤFeᵤP₁₋ₐRₐO₄, when R includes two or more elements R1, R2, ..., and Rn, stoichiometric numbers a1, a2, ..., and an of R1, R2, ..., and Rn need to each fall within a value range defined for a in this application, and a sum of a1, a2, ..., and an need to fall within the value range as well.

It should be noted that a charging/discharging process of a battery is accompanied by intercalation, deintercalation, and consumption of Li, and a molar content of Li varies when the battery is discharged to different states. In this application, a molar content of Li is limited is based on a feeding state of the material, and during a charging and discharging process of the battery, the molar content of Li changes.

The effects of the technical solutions of this application were verified below.

### I. Preparation of secondary battery.

### Preparation of cathode plate:

An active material LiMn_{0.80}Fe_{0.20}PO₄, conductive carbon black Super-P, and a binder PVDF were thoroughly stirred and uniformly mixed at a weight ratio of 97:1:2 in an NMP solvent system; the resulting mixture was applied onto an Al foil, with a coating weight controlled to be 360 g/m²; and the Al foil was dried, cold-pressed, slit, and cut to obtain a cathode plate of a secondary battery.

### Preparation of anode plate:

Graphite, conductive carbon black Super-P, and a binder SBR were thoroughly stirred and uniformly mixed at a weight ratio of 97.4:0.8:1.8 in an H2O solvent system; the resulting mixture was applied onto a Cu foil, with a coating weight controlled to be 0.163 mg/1540 mm²; and the Cu foil was dried, cold-pressed, slit, and cut to obtain an anode plate of a secondary battery.

### Preparation of secondary battery:

A PE/PP/PE three-layer porous polymer film was used as a separator, and propylene carbonate was used as an electrolyte.

The cathode plate, the separator, and the anode plate were wound, and a qualified bare cell was welded onto a top cover through a tab, followed by casing, baking, electrolyte injection, and formation to complete the preparation of a secondary battery.

### II. Charging operation:

The secondary battery was charged according to the charging method described above. Specifically, the secondary battery was first charged with a first charging current until a SOC of the secondary battery reached a preset value, and then the secondary battery was charged with a second charging current until the SOC of the secondary battery reached a fully charged state.

### III. Performance test:

A method for testing the SOC of the battery at 25°C: 1. A secondary battery was made to adapt to a 25°C environment for a period of time; the secondary battery was fully charged with a specific current after a temperature of the secondary battery reached 25°C; then, the secondary battery was left standing at a specified temperature for a period of time for environmental adaptation until the temperature of the secondary battery reached the specified temperature; the secondary battery undergone constant-current discharging at a specific current at the temperature until a cutoff voltage of the secondary battery was reached; and a constant-current discharge capacity was taken as a nominal capacity of the secondary battery. 2. The secondary battery was returned to the 25°C environment to adapt to room temperature for a period of time, the secondary battery is fully charged with a specific current and then left standing at a specified temperature for a period of time for environmental adaptation until the temperature of the secondary battery reached the specified temperature; the nominal capacity obtained in the first step was equally divided into several equal portions; then the secondary battery undergone constant-current discharging with a specific current to each portion of capacity; the secondary battery was left standing for more than 30 min; a voltage value at an end of the standing period was recorded; and the above steps were repeated until the secondary battery was fully discharged.

Capacity testing method + temperature collection: At 25°C, Step 1: the secondary battery was first discharged to a voltage of 2.0 V at 0.1C, recorded as 0% SOC; Step 2: the secondary battery was charged using currents of the comparative example and Examples 1-3, respectively; a SOC and a temperature of the secondary battery were collected during charging; charging was stopped when the voltage reached 4.1 V, which was regarded as the end of charging; and a cell charge capacity was obtained; and Step 3: after a collected temperature of the secondary battery returned to 25°C, the secondary battery was discharged to 2.0 V at a constant current of 0.33C, and a cell discharge capacity was obtained.

For Step 2: In the comparative example of this solution, a constant current of 0.33C was used for charging throughout the process, and charging was stopped when the voltage reached 4.1 V.

Charging was performed according to the following method in Examples 1-3 of this solution. The secondary battery was first charged with a first charging current until a SOC of the secondary battery reached a preset value (40%), then the secondary battery undergone constant-current charging with a second charging current of 0.33C, charging was stopped when the voltage reached 4.1 V, and then the secondary battery was tested according to the above charging method, to obtain temperature collection results and cell charge and discharge capacity results in Table 4.

**Table 3**

| **SOC** | **Charging step** | **Comparative example (C)** | **Example 1 (C)** | **Example 2 (C)** | **Example 3 (C)** |
|---|---|---|---|---|---|
| 0% | | | 4.10 | 2.00 | 1.50 |
| 5% | | | 3.53 | 1.80 | 1.20 |
| 10% | | | 2.95 | 1.70 | 1.10 |
| 15% | | | 2.50 | 1.40 | 0.80 |
| 20% | Charge with first current | | 2.05 | 1.20 | 0.80 |
| 25% | | | 1.79 | 0.80 | 0.70 |
| 30% | | | 1.54 | 0.70 | 0.50 |
| 35% | | | 1.18 | 0.50 | 0.40 |
| 40% | | | 1.09 | 0.40 | 0.40 |
| 45% | | | | | |
| 50% | | 0.33 | | | |
| 55% | | | | | |
| 60% | | | | | |
| 65% | | | | | |
| 70% | Charge with second charging current | | 0.33 | 0.33 | 0.33 |
| 75% | | | | | |
| 80% | | | | | |
| 85% | | | | | |
| 90% | | | | | |
| 95% | | | | | |
| 100% | | | | | |

**Table 4**

| | **Cell temperature at preset SOC (°C)** | **Cell charge capacity (Ah)** | **Cell discharge capacity (Ah)** |
|---|---|---|---|
| **Comparative example** | 28 | 162.7 | 162.1 |
| **Example 1** | 40 | 173.2 | 172.5 |
| **Example 2** | 35.5 | 168.9 | 168.4 |
| **Example 3** | 30.4 | 166.3 | 165.8 |

From the comparative example and Examples 1, 2, and 3 in Table 3, it can be seen that in Examples 1, 2, and 3, under a condition that the SOC value of the secondary battery is less than or equal to 40%, a first charging current that continuously decreases as the SOC value increases is used for charging, and under a condition that the SOC value reaches 40%, constant-current charging is performed at 0.33C; in the comparative example, constant-current charging is performed at 0.33C throughout the entire charging process; and the first charging currents in Examples 1, 2, and 3 are all greater than 0.33C.

Based on the test results obtained in Table 4, it can be learned that in the comparative example, under a condition that a constant current of 0.33C is used for charging to reach a SOC (40%), a cell temperature is 28°C, while in Examples 1, 2, and 3, under a condition that variable first charging currents greater than 0.33C are used for charging to reach a SOC (40%), a cell temperature in Example 1 is 40°C, a cell temperature in Example 2 is 35.5°C, and a cell temperature in Example 3 is 30.4°C. Thus, it can be seen that cell temperatures in the examples are all higher than the cell temperature in the comparative example. Therefore, it can be concluded that charging with a large first charging current can indeed enable a secondary battery to self-generate heat during charging, thereby significantly increasing a cell temperature.

Based on data of the cell charge capacity and cell discharge capacity in the test results obtained in Table 4, cell charge capacities in Examples 1, 2, and 3 are all greater than the cell charge capacity in the comparative example, and the cell discharge capacities in Examples 1, 2, and 3 are all greater than the cell discharge capacity in the comparative example. Therefore, it can be concluded that charging with a large first charging current (greater than 0.33C) under a condition that the SOC value of the secondary battery is less than or equal to 40% and charging with a small constant current of 0.33C under a condition that the SOC value reaches 40% can indeed increase the cell charge capacity and cell discharge capacity.

From data of Examples 1, 2, and 3 in Table 3, it can be seen that the first charging current used in Example 1 is greater than the first charging current used in Example 2, and the first charging current used in Example 2 is greater than the first charging current used in Example 3. Based on this, from data in Table 4, it can be seen that the cell temperature and cell charge and discharge capacities achieved in Example 1 are both greater than the cell temperature and cell charge and discharge capacities in Example 2; and the cell temperature and cell charge and discharge capacities in Example 2 are both greater than the cell temperature and cell charge and discharge capacities in Example 3. Therefore, it can be concluded that a larger first charging current used before the SOC reaches the preset value results in a higher cell temperature achieved by a cell as well as higher charge capacity and discharge capacity that a cell can realize.

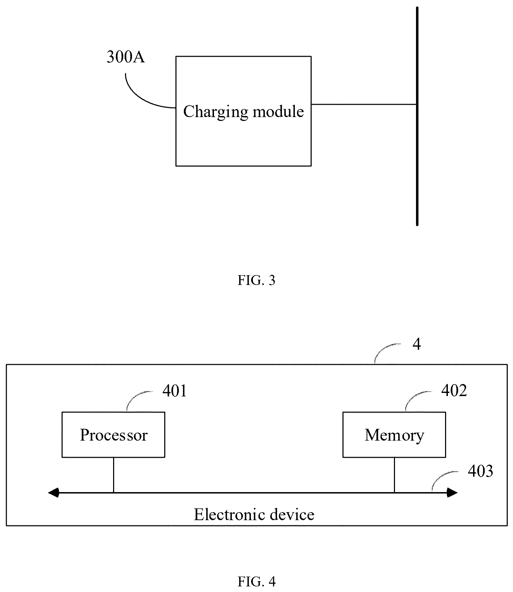

FIG. 3 shows a schematic structural block diagram of a charging apparatus provided by this application. It should be understood that the apparatus corresponds to method embodiments executed in FIG. 1 and FIG. 2, which is capable of performing steps involved in the aforementioned method. Specific functions of the apparatus may refer to the descriptions above. To avoid repletion, detailed descriptions are appropriately omitted here. The apparatus includes at least one software function module that can be stored in a memory in a form of software or firmware (firmware) or solidified in an operating system (operating system, OS) of the apparatus. Specifically, the apparatus includes: a charging module 300A, where the charging module 300A is configured to, during a process of charging a secondary battery, charge the secondary battery with a first charging current until a SOC of the secondary battery reaches a preset value, where a current value of the first charging current decreases as a SOC value of the secondary battery increases; and, under a condition that the SOC of the secondary battery reaches the preset value, charge the secondary battery with a second charging current; where a minimum value of the first charging current is greater than a maximum value of the second charging current. A positive electrode active material of the secondary battery includes LiMPO₄, where M includes Mn and Fe elements.

In the technical solution of the embodiments of this application, according to this solution, during the process of charging the secondary battery, a large first charging current is first used to charge the secondary battery until the SOC of the secondary battery reaches the preset value. Charging with a large first charging current enables the secondary battery to self-generate heat, causing the SOC of the secondary battery to reach the preset value, accompanied by an increase in battery temperature. An increase in a charging temperature of the secondary battery helps to increase a lithium ion deintercalation speed and depth in an Mn plateau segment, not only shortening a charging time of the secondary battery and increasing a charging rate of the secondary battery, but also enhancing capacity utilization of the secondary battery. Additionally, under a condition that the SOC of the secondary battery reaches the preset value, there is an increase or a relatively significant increase in battery temperature. Due to slow heat dissipation during a temperature reduction process, the secondary battery can maintain a relatively high temperature (for example, higher than ambient temperature) during subsequent charging, even when charged with a small second charging current during a subsequent charging process. This can increase a capacity and charging rate of the secondary battery, thereby allowing most of the charging process or the entire charging process of the secondary battery to be performed in a relatively high temperature environment, and further increasing the capacity and charging efficiency of the secondary battery. Simultaneously, charging with a small second charging current can save electrical energy resources while ensuring capacity utilization of the secondary battery. Furthermore, a charging method designed in this solution achieves self-generation of heat through a large cell current (for example, greater than a charging current in a typical constant-current charging process) without modifying a heating device for a cell structure, reducing cell costs while improving the applicability of the designed secondary battery, thereby making the secondary battery suitable for various application scenarios.

According to some embodiments of this application, as shown in FIG. 4, this application provides an electronic device 4, including: a processor 401 and a memory 402, where the processor 401 and the memory 402 are interconnected and communicate with each other through a communication bus 403 and/or other forms of connection mechanisms (not shown). The memory 402 stores a computer program executable by the processor 401, and when a computing device runs, the processor 401 executes the computer program to perform a method executed by an external device in any optional implementation, such as steps S200 and S210: during a process of charging a secondary battery, charge the secondary battery with a first charging current until a SOC of the secondary battery reaches a preset value; and under a condition that the SOC of the secondary battery reaches the preset value, charge the secondary battery with a second charging current.

This application provides a computer-readable storage medium, where a computer program is stored in the computer-readable storage medium, and the computer program, when executed by a processor, performs the method in any optional implementation described above.

The storage medium may be implemented by any type of volatile or non-volatile storage device or a combination thereof, such as static random access memory (Static Random Access Memory, SRAM), electrically erasable programmable read-only memory (Electrically Erasable Programmable Read-Only Memory, EEPROM), erasable programmable read-only memory (Erasable Programmable Read-Only Memory, EPROM), programmable read-only memory (Programmable Read-Only Memory, PROM), read-only memory (Read-Only Memory, ROM), magnetic memory, flash memory, magnetic disk, or optical disk.

This application provides a computer program product, where the computer program product, when running on a computer, causes the computer to perform the method in any optional implementation described above.

In conclusion, it should be noted that: the above embodiments are only used to illustrate the technical solutions of this application rather than to limit them; although this application has been described in detail with reference to the foregoing embodiments, those of ordinary skill in the art should understand that: they can still modify the technical solutions recorded in the foregoing embodiments, or perform equivalent replacements on some or all of technical features therein; and these modifications or replacements do not make the essence of the corresponding technical solutions depart from the scope of the technical solutions of the embodiments of this application, and they should all be covered within the scope of the claims and specification of this application. In particular, as long as there is no structural conflict, various technical features mentioned in the embodiments can be combined in any manner. This application is not limited to specific embodiments disclosed in this specification, but includes all technical solutions falling within the scope of the claims.

## Claims

1. A charging method, **characterized by** comprising:
during a process of charging a secondary battery, charging the secondary battery with a first charging current until a SOC of the secondary battery reaches a preset value; and
under a condition that the SOC of the secondary battery reaches the preset value, charging the secondary battery with a second charging current; wherein a minimum value of the first charging current is greater than a maximum value of the second charging current;
wherein a positive electrode active material of the secondary battery comprises LiMPO₄, wherein M comprises Mn and Fe elements.

2. The charging method according to claim 1, **characterized in that** the positive electrode material comprises at least one of the following materials:
LiMn_{1-y}Fe_{y}PO₄, wherein y is any value in a range of 0.001 to 0.5;
Li₁₊ₜMn_{1-c}Fe_{c}P_{1-z}R_{z}O₄, wherein t is any value in a range of -0.100 to 0.100, c is any value in a range of 0.001 to 0.500, z is any value in a range of 0.001 to 0.100, and R comprises one or more elements selected from B, S, Si, and N; and
Li_{1+w}CₘMn₁₋ᵤFeᵤP₁₋ₐRₐO₄₋ₙDₙ, wherein C comprises one or more elements selected from Zn, Al, Na, K, Mg, Nb, Mo, and W, R comprises one or more elements selected from B, S, Si, and N, D comprises one or more elements selected from S, F, Cl, and Br, w is any value in a range of -0.100 to 0.100, u is any value in a range of 0.001 to 0.500, a is any value in a range of 0.001 to 0.100, n is any value in a range of 0.001 to 0.1, and m is any value in a range of 0.001 to 0.1.

3. The charging method according to claim 1, **characterized in that** a current value of the first charging current decreases as a SOC value of the secondary battery increases.

4. The charging method according to claim 1, **characterized in that**, before a SOC value of the secondary battery reaches a preset value, a plurality of SOC intervals are provided, wherein each SOC interval corresponds to a charging current, and different SOC intervals correspond to different charging currents; wherein the first charging current comprises charging currents corresponding to different SOC intervals.

5. The charging method according to claim 1, **characterized in that** a charging current corresponding to a SOC interval is less than or equal to a maximum charging current allowed by a minimum SOC value in the corresponding SOC interval.

6. The charging method according to claim 1, **characterized in that**, before a SOC value of the secondary battery reaches a preset value, a plurality of SOC intervals are provided, wherein each SOC interval corresponds to a charging current range; in different SOC intervals, a current within the charging current range is selected as needed for charging; and the first charging current comprises currents within the plurality of SOC intervals.

7. The charging method according to claim 1, **characterized in that** a current value of the second charging current is a constant value.

8. The charging method according to claim 1, **characterized in that** a current value of the second charging current decreases as a SOC value increases.

9. The charging method according to claim 1, **characterized in that** the first charging current is any current from 0.36C to 4.92C, and the second charging current is any current from 0.3C to 1.0C.

10. The charging method according to claim 1, **characterized in that** the preset value is f*S, wherein f is a molar proportion of Fe element in the Mn and Fe elements in the positive electrode active material, and S is a SOC value of the secondary battery in a fully charged state.

11. A charging apparatus, **characterized in that** the apparatus comprises a charging module;
wherein the charging module is configured to charge a secondary battery according to the method described in any one of claims 1 to 10;
wherein a positive electrode active material of the secondary battery comprises LiMPO₄, wherein M comprises Mn and Fe elements.

12. An electronic device, comprising a memory and a processor, wherein the memory has a computer program stored therein; and the electronic device is **characterized in that** the processor, when executing the computer program, implements the method described in any one of claims 1 to 10.

13. A computer-readable storage medium, having a computer program stored therein, and **characterized in that** the computer program, when executed by a processor, implements the method described in any one of claims 1 to 10.
